# EUROPEAN PATENT SPECIFICATION

(11) **EP 2 039 801 B1**
(45) Date of publication and mention of the grant of the patent: **26.09.2012**
(21) Application number: 07745295.1
(22) Date of filing: 14.06.2007
(51) Int. Cl.: H01J 37/32

(54) **METHOD FOR FORMING THIN FILM**
VERFAHREN ZUR BILDUNG EINES DÜNNFILMS
PROCÉDÉ DE FORMATION D'UN FILM MINCE

(30) Priority: 16.06.2006 JP 2006167922
(43) Date of publication of application: 25.03.2009
(73) Proprietor: Asahi Glass Company, Limited, Chiyoda-ku Tokyo 100-8405 (JP)
(72) Inventor: AOMINE, Nobutaka, Tokyo 100-8405 (JP); AOSHIMA, Yuki, Tokyo 100-8405 (JP); HAYASHI, Kazushi, Kobe-shi, Hyogo 651-2271 (JP); KUGIMIYA, Toshihiro, Kobe-shi, Hyogo 651-2271 (JP); KOBORI, Takashi, Kobe-shi, Hyogo 651-2271 (JP)
(74) Representative: Hock, Joachim
(86) International application number: PCT/JP2007/062038
(87) International publication number: WO 2007/145292

(56) References cited:
- JP-A- 2 267 274
- JP-A- 2003 013 237
- JP-A- 2003 193 241
- JP-A- 2004 107 788
- JP-A- 2005 107 044
- US-A- 5 711 814
- US-B1- 6 586 055

## Description

### TECHNICAL FIELD

The present invention relates to a method for forming a thin film, which comprises forming a thin film on a substrate by using a generated plasma and a reaction gas supplied to such a plasma-generated region.

### BACKGROUND ART

Heretofore, as an apparatus to form a thin film on a substrate, plasma CVD has been known wherein a plasma is generated in an atmosphere relatively close to atmospheric pressure, and by using such a plasma, a reaction gas is activated in a reactor to form a thin film by deposition on a substrate. For such plasma CVD, a parallel flat plates-type apparatus is preferably employed which is designed to supply a high frequency electric power between a pair of parallel electrode plates to generate a plasma between the electrode plates.

Whereas, in the following Patent Document 1, an apparatus and method are disclosed wherein a high frequency electric power or DC electric power is applied to a drum-shaped rotating electrode to generate a plasma, and using the generated plasma, a supplied reaction gas is activated to form a thin film on a substrate. It is thereby possible to form a uniform thin film at a high rate over a large area and to solve a conventional problem such that it is difficult to form a uniform thin film at the time of forming a thin film over a large area in a conventional parallel flat plates type.

US5711814 discloses a method to form a thin film by plasma enhanced chemical vapour deposition using a rotary electrode, a high frequency power supply, wherein atmospheric pressure is applied.
Patent Document 1: Japanese Patent No. 3,295,310

### DISCLOSURE OF THE INVENTION

### PROBLEMS TO BE SOLVED BY THE INVENTION

In the apparatus of Patent Document 1, a plasma is generated at a portion where the space between the rotating electrode and the substrate becomes narrow (the distance of the space which becomes narrowest is at most 1 mm), and the generated plasma is employed to activate a reaction gas to form a thin film, and accordingly, the region where a thin film is to be formed, is limited to the vicinity of the portion where the space between the rotating electrode and the substrate becomes narrowest. Therefore, it is required to form a thin film while relatively moving or transporting the substrate relative to the rotating electrode. Such movement or transportation of the substrate is controlled via a driving means such as a motor, but the space between the rotating electrode and the substrate changes by slight vibration at the time of the movement or transportation, and there is a problem such that by such a change, it becomes difficult to form a homogeneous thin film.
Further, in a case where the above space is made narrow in order to efficiently generate the plasma, there will be a problem such that the rotating electrode is likely to be in contact with the substrate even by a slight change by e.g. vibration.

On the other hand, if it is attempted to avoid the above problems or disadvantages by increasing the space between the rotating electrode and the substrate, fine particles will be formed in a large amount by a reaction of a reaction gas activated by the plasma and will be deposited on the thin film formed on the substrate, thus leading to a problem such that it becomes difficult to form a smooth homogeneous thin film with little irregularities. In fact, by the method for forming a thin film disclosed in Patent Document 1, even if the space between the rotating electrode and the substrate is made large, such a problem will result, and it is impossible to obtain a homogeneous film.

Under the circumstances, in order to solve the above problems, it is an object of the present invention to provide a method for forming a thin film, whereby it is possible to suppress formation of fine particles even when the space between the rotating electrode and the substrate is set to be wider than a conventional method, and there will be little influence by a change of such a space in homogenization of the thin film.

### MEANS TO SOLVE THE PROBLEMS

The present invention provides a method for forming a thin film in an atmosphere with at least 900 hPa, which comprises supplying an electric power to a cylindrical rotating electrode whose rotational center axis is parallel to a substrate, to generate a plasma in a space between this rotating electrode and the substrate, and to chemically react a supplied reaction gas by means of the generated plasma to form a thin film on the substrate, wherein the space distance between the rotating electrode and the substrate is from 2 mm to 7 mm, and a high-frequency electric power having a frequency of from 100 kHz to 1 MHz is supplied to the rotating electrode.

At that time, the above frequency is preferably from 300 kHz to 800 kHz. In the present invention, the space distance between the rotating electrode and the substrate means the narrowest space portion (hereinafter referred to also as a gap) of the space between the rotating electrode and the substrate. In the present invention, the space distance between the rotating electrode and the substrate is preferably from 3 mm to 5 mm.

As the above thin film, it is preferred to form a metal oxide film. At that time, the metal oxide film is preferably at least one oxide film selected from the group consisting of SiO₂, TiO₂, ZnO and SnO₂. More preferably, the metal oxide film is an oxide film of SiO₂ or TiO₂.

Further, the substrate on which the thin film is to be formed, may, for example, be a glass plate having transparency, but the substrate is not limited thereto.

Further, in the method for forming a thin film, it is preferred to form the thin film on the substrate, while the substrate is transported against the rotating electrode in a direction approximately perpendicular to the rotational center axis.

### EFFECTS OF THE INVENTION

In the present invention, a high frequency electric power having a frequency of from 100 kHz to 1 MHz is applied to the rotating electrode, whereby the generated plasma density decreases as compared with a conventional high frequency electric power having a higher frequency such as 13.56 MHz or 60 MHz. Therefore, even when the space distance between the rotating electrode and the substrate is set to be wider than the conventional method, it is possible to suppress formation of a large amount of particles formed by a reaction of the reaction gas activated by the plasma. As a result, it is possible to form a homogeneous thin film having little irregularities on a substrate. Further, by supplying a high frequency electric power of from 100 kHz to 1 MHz to the rotating electrode, reactive species activated in the plasma can reach the substrate without being consumed in the gas phase, whereby formation of particles will be suppressed, even when the space distance between the rotating electrode and the substrate is set to be wider than a conventional method. Therefore, even when the space between the rotating electrode and the substrate is set to be wider than a conventional method, it is possible to form a homogeneous thin film with little irregularities.

Further, the space distance between the rotating electrode and the substrate is at least 2 mm, whereby even in a case where transportation is carried out by a rotary furnace or conveyer belt, it is possible to prevent contact of the substrate with the rotating electrode, and the discharge voltage will be high as compared with the conventional high frequency electric power having a higher frequency such as 13.56 MHz or 60 MHz, whereby discharge can be carried out at a portion where the space distance between the rotation electrode and the substrate is wide, whereby the plasma-generated region will be broadened, and the deposition rate is higher than the conventional deposition rate of the same space distance, whereby a thin film can be formed constantly in a short time. It is thereby possible to carry out formation of a homogeneous thin film with a large area at a high rate and constantly as compared with the conventional method.

### BRIEF DESCRIPTION OF THE DRAWINGS

Fig. 1(a) is a schematic view of an apparatus for forming a thin film to carry out the method for forming a thin film of the present invention, and Fig. 1(b) is a schematic view of the apparatus for forming a thin film, as viewed from its side.
Fig. 2 is a graph showing the relationship between the gap between the rotating electrode and the substrate, and the haze ratio of a thin film thereby formed.
Fig. 3(a) is a SEM photographic image of 35,000 magnifications when the surface morphology of a thin film formed on a substrate with a high frequency electric power of 400 kHz with a gap of 5 mm, was photographed, and Fig. 3(b) is a SEM photographic image of 35,000 magnifications when the surface morphology of a thin film formed on a substrate with a high frequency electric power of 13.56 MHz with a gap of 3 mm, was photographed.
Fig. 4 is a graph showing the relationship between the gap between the rotating electrode and the substrate, and the deposition rate at that time.
Fig. 5(a) is a graph showing the deposition rate distribution at a frequency of 400 kHz, and Fig. 5(b) is a graph showing the deposition rate distribution at 13.56 MHz.

### MEANINGS OF SYMBOLS

- 10:: Apparatus for forming thin film
- 12:: Rotating electrode
- 14:: Apparatus for transporting substrate
- 16:: High frequency electric power supply

### BEST MODE FOR CARRYING OUT THE INVENTION

Now, the method for forming a thin film of the present invention will be described in detail with referenced to the embodiment shown in the accompanying drawings.

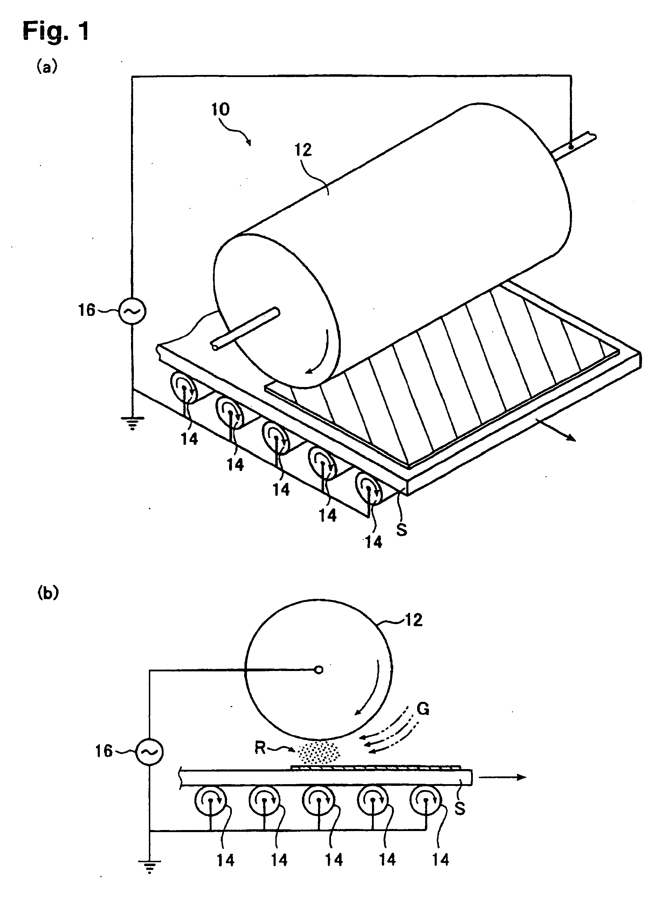

Fig. 1(a) is a schematic view illustrating an apparatus 10 for forming a thin film to carry out the method for forming a thin film of the present invention, and Fig. 1(b) is a schematic view of the apparatus 10 for forming a thin film as viewed from its side.

The apparatus 10 for forming a thin film is a so-called plasma CVD apparatus whereby a plasma is generated in an atmosphere with at least 900 hPa close to atmospheric pressure, and this plasma is utilized to activate a supplied reaction gas G thereby to form a thin film on a substrate S. The apparatus 10 for forming a thin film is composed mainly of a rotating electrode 12, an apparatus 14 for transporting the substrate and a high frequency electric power supply 16.

The rotating electrode 12 is constituted by a cylindrical rotating body made of a metal having a smooth surface and having a rotational center axis parallel to the substrate. The rotating electrode 12 is connected with a driving motor not shown and is rotated at a peripheral speed of e.g. from 2 m/sec to 50 m/sec.

The rotating electrode 12 is rotated in order to positively take the reaction gas G into the plasma-generating region R in an atmosphere close to atmospheric pressure thereby to efficiently activate the reaction gas G. To generate a plasma in an atmosphere close to atmospheric pressure, it is required to reduce the space distance between the substrate and the electrode in order to carry out stabilized discharge. On the other hand, if the space distance between the substrate and the electrode is reduced, the reaction gas can not efficiently be supplied as a starting material for the thin film. Therefore, the rotating electrode 12 is used so that by the rotation of the rotating electrode 12, the reaction gas is drawn to create a viscous flow thereby to effectively supply the reaction gas to the space between the electrode and the substrate. Especially, in order to form a thin film in a short time, it is necessary to improve the deposition rate, and for the improvement of the deposition rate, it is desired to efficiently supply the reaction gas.

The space distance between the rotating electrode 12 and the substrate S is from 2 mm to 7 mm. If the space distance exceeds 7 mm, the deposition rate tends to decrease, and it tends to be difficult to obtain a stabilized plasma.

The space distance between the rotating electrode 12 and the substrate S is more preferably from 3 mm to 5 mm. In a conventional film-forming method (the film-forming method in the above Patent Document 1), the space distance is from 0.01 mm to 1 mm, whereas in the present invention, it is at least 2 mm, thus being substantially different.

As a discharge gas to generate a plasma, He gas may, for example, be used, and it is supplied to the space between the rotating electrode 12 and the substrate S. Further, with respect to the reaction gas G, in a case where e.g. a SiO₂ thin film is to be formed on the substrate S, TEOS (tetraethoxysilane; tetraethyl orthosilicate) is used as the source gas, and O₂ is used as oxidizing gas. In such a case, the partial pressure of TEOS is made to be 8 hPa (=6 Torr), and the partial pressure of O₂ is made to be 16 hPa (=12 Torr), and further, the total pressure including He as the discharge gas is made to be 1,013 hPa (=760 Torr). Here, in the present invention, from the viewpoint of efficiency in the adjustment of the pressure and simplicity of the construction of the apparatus, the total pressure is preferably at most 1,100 hPa. In the present invention, the total pressure of the atmosphere for forming a thin film by plasma CVD is more preferably from 930 hPa (700 Torr) to 1,030 hPa (770 Torr).

The substrate-transporting apparatus 14 is an apparatus to relatively move the position of the substrate S against the rotating electrode 12 in order to form a thin film on the substrate S. Specifically, the substrate S is transported at a constant moving speed by rollers connected to e.g. a driving motor not shown. Here, if the substrate S is transported during film-forming, along with the movement, the position of the substrate S delicately changes in the up-and-down direction by e.g. vibration, and the space between the rotating electrode 12 and the substrate S consequently changes. Such a change presents an influence over the deposition rate in the conventional method. However, in the method for forming a thin film of the present invention, the above-mentioned space distance is set to be within a range of from 2 mm to 7 mm, preferably from 3 mm to 5 mm, as described hereinafter, whereby it is possible to minimize the influence over the deposition rate, of the change in the space distance, together with the frequency of the supplied electric power which will be described hereinafter, and such will contribute to formation of a homogeneous thin film.

The transporting system of the substrate-transporting apparatus 14 may be a transporting system employing not only rollers but also an endless belt. In the present invention, the transportation system is not particularly limited.

The high frequency electric power supply 16 is one to supply a high frequency electric power to the rotating electrode 12 via the rotational center axis of the rotating electrode 12. The frequency of the high frequency electric power is from 100 kHz to 1 MHz.

In a conventional film-forming method (the above Patent Document 1), such a frequency is at least 13.56 MHz, preferably at least 150 MHz, while in the present invention, it is within a range of from 100 kHz to 1 MHz.

The reason for such a difference in the range of the frequency from the conventional thin-film forming method is such that, as mentioned above, the space distance between the rotating electrode 12 and the substrate S is at least 2 mm, and the frequency is set to be suitable for this space distance. By setting the frequency to be from 100 kHz to 1 MHz, it is possible to suppress the formation of particles and to form a smooth thin film, as will be described hereinafter.

The lower limit of the frequency is set to be 100 kHz, since in an atmosphere in the vicinity of atmospheric pressure, constant discharge can not be attained with the space distance of at least 2 mm. On the other hand, the upper limit of the frequency is set to be 1 MHz in order to prevent disturbance against formation of a thin film (such as a decrease in the deposition rate or formation of a thin film having large irregularities) by particles formed by a gas phase reaction with the space distance of at least 2 mm.

Heretofore, a reaction gas is supplied to a plasma region formed by applying a high frequency electric power having a frequency of at least 13.56 MHz, whereby the reaction gas is activated by the plasma energy, and a thin film is formed on the substrate surface. However, if the above space is increased, the reaction gas undergoes a secondary reaction to grow particles in the gas phase thus leading to formation of a large amount of particles, before the reaction gas reaches the substrate surface. However, as in the present invention, when the frequency of the high frequency electric power is set to be from 100 kHz to 1 MHz, the generated plasma density is suppressed, and the secondary reaction by the plasma energy is suppressed, whereby formation of a large amount of particles is suppressed. With a view to obtaining a film of good quality free from particles, the frequency of the high frequency electric power is preferably from 300 kHz to 800 kHz.

As described above, in the present invention, the rotational speed of the cylindrical rotating electrode is utilized to draw the reaction gas into the plasma-generating region thereby to carry out the film formation.

### EXAMPLES

### EXPERIMENT 1

Thin films were formed by using the method for forming a thin film of the present invention and a conventional method for forming a thin film.

A glass substrate was used as the substrate S, and a SiO₂ film was formed on the glass substrate. The diameter of the rotating electrode 12 was 100 mm, and the rotational speed of the rotating electrode was 2,500 rpm.

The frequency of the high frequency electric power was 400 kHz in the method for forming a thin film of the present invention, while in the conventional method for forming a thin film, 13.56 MHz was used.

While He to form a plasma was taken into a reactor chamber enclosing the apparatus shown in Fig. 1(a) and (b) as a discharge gas, TEOS was taken into the reactor as a source gas G.

Further, O₂ was taken into the reactor as an oxidizing gas. The partial pressure of the source gas in the reactor was set to be 8 hPa (=6 Torr), and the partial pressure of O₂ as the oxidizing gas was set to be 16 hPa (=12 Torr). The total pressure including He as the discharge gas was set to be 1,013 hPa (=760 Torr). The transportation speed of the substrate S was 3.3 mm/sec or 0 mm/sec (stopped state).

In the case of a high frequency electric power having a frequency of 400 kHz, an electric power of 300 W was supplied, and in the case of a frequency of 13.56 MHz, an electric power of 800 W was supplied.

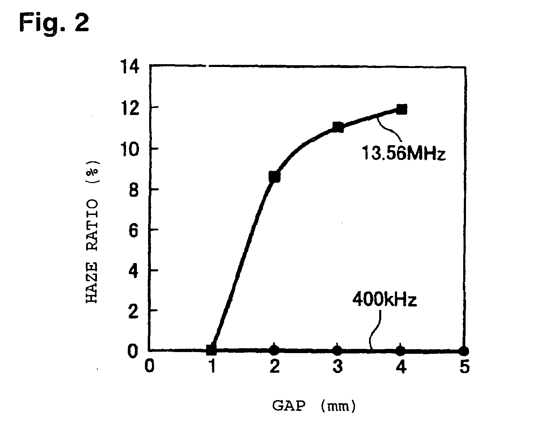

Fig. 2 is a graph showing the relation between the space distance (gap) between the rotating electrode 12 and the substrate S, and the haze ratio of a thin film thereby formed.

As is evident from the graph shown in Fig. 2, with the high frequency electric power of 400 kHz, the haze ratio of the formed thin film is about 0% within a gap range of from 1 mm to 5 mm. This indicates that the formed thin film has a smooth surface, and no particles are deposited on the thin film. On the other hand, with the high frequency electric power of 13.56 MHz, a thin film was formed with a gap of from 1 mm to 4 mm, but no thin film was formed with a gap of 5 mm. Further, the larger the gap, the larger the haze ratio. It is thereby considered that the reaction gas undergoes a secondary reaction to form particles in the gas phase before the reaction gas reaches the substrate surface, and such particles will deposit on a thin film formed on the substrate, whereby the thin film surface will have irregularities.

In this experiment, a haze ratio was used as an index of the irregularities of the surface of a formed thin film, and evaluation was carried out by measuring such a haze ratio. The haze ratio utilizing the dispersion of light by irregularities of the surface to be measured is one wherein the ratio of the diffused transmittance to the total light transmittance is represented by %. The details are defined in JIS K7136 and K7361.

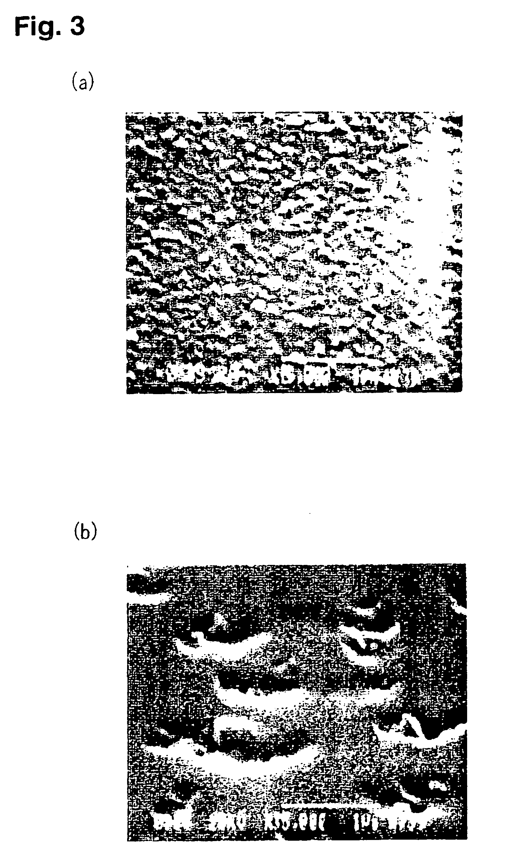

Fig. 3(a) is a SEM photographic image when the surface morphology of a thin film formed on a substrate S by a high frequency electric power of 400 kHz with a gap of 5 mm, was photographed, and Fig. 3(b) is a SEM photographic image when the surface morphology of a thin film formed on a substrate S by a high frequency electric power of 13.56 MHz with a gap of 3 mm, was photographed.

It is evident that the surface irregularities of the thin film shown in Fig. 3(b) are larger than the surface irregularities of the thin film shown in Fig. 3(a), and on the surface of the thin film shown in Fig. 3(b), a large amount of particles deposited during the film formation to form such irregularities.

Thus, it is possible to form a homogeneous thin film free from particles by adjusting the frequency of the high frequency electric power to be supplied at a level of from 100 kHz to 1 MHz.

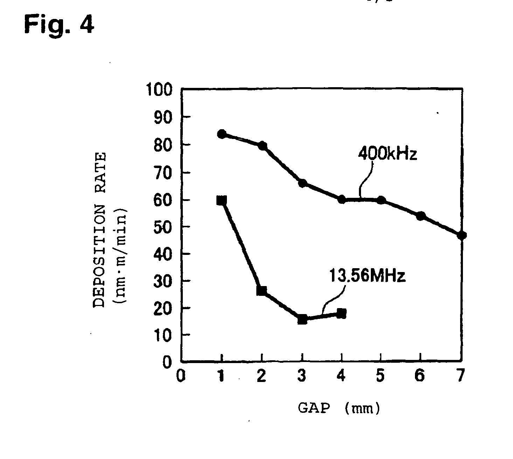

Fig. 4 is a graph showing the relation between the gap between the rotating electrode 12 and the substrate S, and the deposition rate at that time.

The unit (nm·m/min) of the deposition rate shown in Fig. 4 means the product of the transporting speed (m/min) of the substrate S per minute and the thickness (nm) of the thin film thereby formed.

From Fig. 4, it is evident that the larger the gap, the lower the deposition rate in both cases of the frequencies being 400 kHz and 13.56 MHz. However, the decrease in the deposition rate owing to the gap is smaller in the case of the frequency of 400 kHz, thus indicating less susceptibility to influence of the gap, as compared with the case of the frequency of 13.56 MHz. Accordingly, with a gap of from 1 mm to 7 mm, the deposition rate is high (showing an improvement in the deposition rate) in the case of the frequency of 400 kHz as compared with the case of the frequency of 13.56 MHz. The reason for the higher deposition rate in the case of the frequency of 400 kHz as compared with the case of the frequency of 13.56 MHz, is that in the case of the frequency of 400 kHz, the proportion of the activated molecules of the reaction gas becoming particles by the secondary reaction is small, and a thin film is more efficiently formed on the substrate S.

Thus, by adjusting the frequency of the high frequency electric power to be supplied to a level of from 100 kHz to 1 MHz, it is possible to realize improvement of the deposition rate and stability of the deposition rate to a change of the gap.

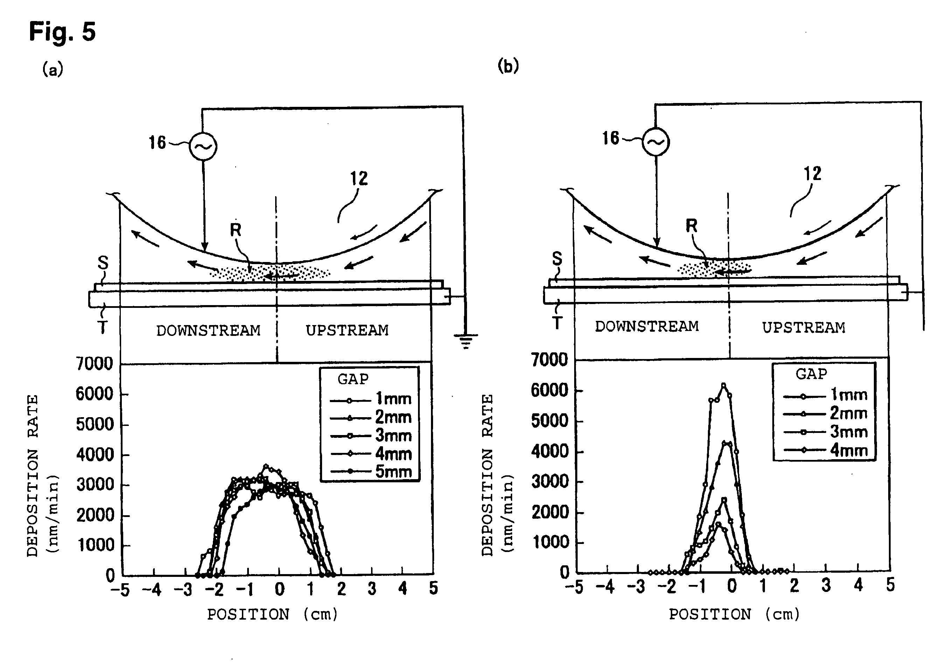

Fig. 5(a) is a graph showing the distribution of the deposition rate at a frequency of 400 kHz, and Fig. 5(b) is a graph showing the distribution of the deposition rate at a frequency of 13.56 MHz.

The abscissa in the graph shows the position on the substrate S relative to the rotating electrode 12. The position at which the space between the rotating electrode 12 and the substrate S is narrowest is designated as 0, and the position on the upstream side in the rotational direction of the rotating electrode 12 is designated to be positive, and the position on the downstream side is designated to be negative. In Figs. 5(a) and (b), the transporting speed of the substrate S is in a resting state, and the substrate S is mounted on a ground plate T and is stationary against the rotating electrode 12.

Also in this case, like in the previous case, a SiO₂ film was formed on the glass substrate by setting the partial pressure of the source gas TEOS in the reactor to be 8 hPa (=6 Torr), the partial pressure of the oxidizing gas O₂ to be 16 hPa (=12 Torr) and the total pressure including He as the discharge gas to be 1,013 hPa (=760 Torr).

Fig. 5(a) shows the distribution of the deposition rate under the condition of the frequency of the high frequency electric power being 400 kHz for each of gaps of 1 mm to 5 mm, and Fig. 5(b) shows the distribution of the deposition rate under a condition of the frequency of the high frequency electric power being 13.56 MHz for each of gaps 1 mm to 4 mm. Further, the integrated values of the deposition rates at the respective positions in Figs. 5(a) and (b) generally correspond to the deposition rates in Fig. 4.

As is evident from Fig. 5(a), the distribution of the deposition rate at a frequency of 400 kHz has a broad width and shows a constant distribution shape substantially non-changeable by a change in the gap. On the other hand, as is evident from Fig. 5(b), the distribution of the deposition rate at a frequency of 13.56 MHz has a sharp shape and shows a large change in the peak level of the deposition rate depending upon the gap size (the deposition rate tends to be small as the gap increases). This means that with a frequency of 400 kHz, a sufficiently wide plasma-generating region R can be secured, and a broad distribution of the deposition rate can be obtained. Yet, it is considered that even if the gap varies, the change in the plasma-generating region R is little, and even if the gap varies the change in the deposition rate is little.

As a result, even if the substrate S is transported during the film formation, and the gap varies due to e.g. vibration during the transportation, the deposition rate remains to be substantially constant against the gap at the frequency of 400 kHz, whereby the thickness of the thin film to be formed will be substantially constant. Thus, the deposition rate is stable against a change in the gap at the frequency of 400 kHz (stability of the deposition rate).

Further, the type of the thin film to be formed in the present invention is not particularly limited, but it is preferably a metal oxide film. For example, it is at least one metal oxide film selected from the group consisting of SiO₂, TiO₂, ZnO and SnO₂, formed on a glass substrate. More preferably, it is a metal oxide film of SiO₂ or TiO₂ formed on a glass substrate.

Further, as the source gas, in addition to TEOS, an organic metal compound such as a metal alkoxide, an alkylated metal or a metal complex, or a metal halide may, for example, be used. For example, tetraisopropoxytitanium, tetrabutoxytitanium, dibutyltin diacetate or zinc acetylacetonate may suitably be used.

### EXPERIMENT 2

In the same manner as in Experiment 1, film formation was carried out by changing the frequency and the gap as shown in the following Table 1, and the haze ratio was measured as an index showing the irregularities of the thin film surface thereby to evaluate the thin film. The haze ratio being less than 1% was identified by ⊚, the haze ratio being at most 2% was identified by ○, and the haze ratio being more than 2% was identified by ×. The results are shown in Table 1.

**TABLE 1**

| Example | | Frequency | Gap (mm) | Evaluation | Haze ratio | Others |
|---|---|---|---|---|---|---|
| 1 | Comparative Example | 13.56 MHz | 5 | × | - | Discharge impossible |
| 2 | Comparative Example | 13.56 MHz | 3 | × | 11% | |
| 3 | Comparative Example | 12 MHz | 5 | × | 8% | |
| 4 | Comparative Example | 12 MHz | 2 | × | 4% | |
| 5 | Present invention | 1 MHz | 7 | ○ | 2% or less | |
| 6 | Present invention | 1 MHz | 2 | ○ | 2% or less | |
| 7 | Present invention | 800 kHz | 7 | ⊚ | Less than 1% | |
| 8 | Present invention | 800 kHz | 2 | ⊚ | Less than 1% | |
| 9 | Present invention | 300 kHz | 2 | ⊚ | Less than 1% | |
| 10 | Present invention | 300 kHz | 7 | ⊚ | Less than 1% | |
| 11 | Present invention | 100 kHz | 2 | ○ | 2% or less | |
| 12 | Present invention | 100 kHz | 7 | ○ | 2% or less | |
| 13 | Comparative Example | 50 kHz | 2 | × | 3.5% | |
| 14 | Comparative Example | 50 kHz | 5 | × | - | Abnormal discharge |

As is evident from the results of Examples 5 to 12 which were working examples of the present invention, in each case, it was possible to obtain a smooth thin film having little irregularities with a haze ratio of 2% or less at a frequency within a range of from 100 kHz to 1 MHz with a gap within a range of from 2 mm to 7 mm. Further, from the results of Examples 7 to 10, it is evident that a good film with a haze ratio of less than 1% was obtained at a frequency within a range of from 300 kHz to 800 kHz with a gap within a range of from 2 mm to 7 mm. Whereas, in Examples 1 to 3 and 13, the haze ratio exceeded 2%, and the thin film became non-homogeneous with large surface irregularities. Further, in Examples 4 and 14, no constant discharge was obtainable.

From the foregoing results, it is evident that a thin film to be formed by the method of the present invention is a smooth thin film having little irregularities.

### INDUSTRIAL APPLICABILITY

The present invention is applicable to an anti reflection glass (film), IR cut glass (film), alkali barrier coated glass, gas barrier coated glass (film), self-cleaning coated glass (film), etc., which are prepared by optionally laminating SiO₂, TiO₂, ZnO, SnO₂, etc. on a glass or film substrate.

The entire disclosure of Japanese Patent Application No. 2006-167922 filed on June 16, 2008 including specification, claims, drawings and summary is incorporated herein by reference in its entirety.

## Claims

1. A method for forming a thin film in an atmosphere with at least 900 hPa, which comprises supplying an electric power to a cylindrical rotating electrode whose rotational center axis is parallel to a substrate, to generate a plasma in a space between this rotating electrode and the substrate, and to chemically react a supplied reaction gas by means of the generated plasma to form a thin film on the substrate, wherein the space distance between the rotating electrode and the substrate is from 2 mm to 7 mm, and a high-frequency electric power having a frequency of from 100 kHz to 1 MHz is supplied to the rotating electrode.

2. The method for forming a thin film according to Claim 1, wherein as the thin film, a metal oxide film is formed.

3. The method for forming a thin film according to Claim 2, wherein the metal oxide film is at least one oxide film selected from the group consisting of SiO₂, TriO₂, ZnO and SnO₂.

4. The method for forming a thin film according to any one of Claims 1 to 3, wherein the frequency of the high-frequency electric power, is from 300 kHz to 800 kHz.

5. The method for forming a thin film according to any one of Claims 1 to 4, wherein the pressure of the atmosphere is at most 1100 hPa.

6. The method for forming a thin film according to any one of Claims 1 to 5, wherein.the space distance between the rotating electrode and the substrate is from 3 mm to 5 mm.

7. The method for forming a thin film according to any one of Claims 1 to 6, wherein the thin film is formed on the substrate, while the substrate is transported against the rotating electrode in a direction approximately perpendicular to the rotational center axis.

## Patentansprüche

1. Verfahren zum Bilden eines dünnen Films in einer Atmosphäre mit mindestens 900 hPa, welches das Zuführen einer elektrischen Energie an eine zylindrische rotierende Elektrode, deren Rotationsmittelachse parallel zu einem Substrat ist, umfasst, um ein Plasma in einem Raum zwischen dieser rotierenden Elektrode und dem Substrat zu erzeugen und um chemisch ein zugeführtes Reaktionsgas mittels des erzeugten Plasmas chemisch umzusetzen, um einen dünnen Film auf dem Substrat zu bilden, wobei der Raumabstand zwischen der rotierenden Elektrode und dem Substrat von 2 mm bis 7 mm beträgt und eine hochfrequente elektrische Energie mit einer Frequenz von 100 kHz bis 1 MHz der rotierenden Elektrode zugeführt wird.

2. Verfahren zum Bilden eines dünnen Films gemäß Anspruch 1, wobei als der dünne Film ein Metalloxidfilm gebildet wird.

3. Verfahren zum Bilden eines dünnen Films gemäß Anspruch 2, wobei der Metalloxidfilm mindestens ein Oxidfilm ist, ausgewählt aus der Gruppe, bestehend aus SiO₂, TiO₂, ZnO und SnO₂.

4. Verfahren zum Bilden eines dünnen Films gemäß einem der Ansprüche 1 bis 3, wobei die Frequenz der hochfrequenten elektrischen Energie von 300 kHz bis 800 kHz beträgt.

5. Verfahren zum Bilden eines dünnen Films gemäß einem der Ansprüche 1 bis 4, wobei der Druck der Atmosphäre höchstens 1100 hPa beträgt.

6. Verfahren zum Bilden eines dünnen Films gemäß einem der Ansprüche 1 bis 5, wobei der Raumabstand zwischen der rotierenden Elektrode und dem Substrat von 3 mm bis 5 mm beträgt.

7. Verfahren zum Bilden eines dünnen Films gemäß einem der Ansprüche 1 bis 6, wobei der dünne Film auf dem Substrat gebildet wird, während das Substrat gegen die rotierende Elektrode in einer Richtung annähernd senkrecht zu der Rotationsmittelachse transportiert wird.

## Revendications

1. Procédé pour former un film mince dans une atmosphère à au moins 900 hPa, qui comprend l'alimentation d'un courant électrique à une électrode rotative cylindrique dont l'axe central de rotation est parallèle à un substrat, pour produire un plasma dans un espace situé entre cette électrode rotative et le substrat, et faire réagir chimiquement un gaz de réaction alimenté par l'intermédiaire du plasma produit pour former un film mince sur le substrat, dans lequel la distance de l'espace entre l'électrode rotative et le substrat est de 2 à 7 mm, et un courant électrique haute fréquence ayant une fréquence allant de 100 kHz à 1 MHz est fourni à l'électrode rotative.

2. Procédé pour former un film mince selon la revendication 1, dans lequel en tant que film mince, un film d'oxyde métallique est formé.

3. Procédé pour former un film mince selon la revendication 2, dans lequel le film d'oxyde métallique est au moins un film d'oxyde sélectionné parmi le groupe constitué de SiO₂, TiO₂, ZnO et SnO₂.

4. Procédé pour former un film mince selon l'une quelconque des revendications 1 à 3, dans lequel la fréquence du courant électrique haute fréquence est de 300 kHz à 800 kHz.

5. Procédé pour former un film mince selon l'une quelconque des revendications 1 à 4, dans lequel la pression de l'atmosphère est au maximum de 1100 hPa.

6. Procédé pour former un film mince selon l'une quelconque des revendications 1 à 5, dans lequel la distance de l'espace entre l'électrode rotative et le substrat est de 3 mm à 5 mm.

7. Procédé pour former un film mince selon l'une quelconque des revendications 1 à 6, dans lequel le film mince est formé sur le substrat, alors que le substrat est transporté contre l'électrode rotative dans une direction approximativement perpendiculaire à l'axe central de rotation.
